# FASCICULE DE BREVET EUROPEEN

(11) **EP 0 612 869 B1**
(45) Date de publication et mention de la délivrance du brevet: **17.04.1996**
(21) Numéro de dépôt: 94410009.8
(22) Date de dépôt: 23.02.1994
(51) Int. Cl.: C30B 31/14

(54) **Nacelle pour plaquettes de silicium**
Trägerkassette für Siliziumscheiben
Waferbasket for silicon wafers

(30) Priorité: 24.02.1993 FR 9302340
(43) Date de publication de la demande: 31.08.1994
(73) Titulaire: SGS-THOMSON MICROELECTRONICS S.A., F-94250 Gentilly (FR)
(72) Inventeur: Letort, Xavier, F-37540 Saint Cyr/Loire (FR)
(74) Mandataire: de Beaumont, Michel

(56) Documents cités:
- EP-A- 0 166 032
- EP-A- 0 308 695
- FR-A- 2 144 678

## Description

La présente invention concerne une nacelle modulable pour plaquettes de semiconducteur de tout diamètre.

L'industrie des composants semiconducteurs utilise des plaquettes de silicium que l'on soumet à divers traitements. Ces traitements nécessitent l'utilisation de nacelles, généralement en quartz ou en silicium, permettant le maintien en position verticale des plaquettes de silicium. Pour optimiser le coût des composants semiconducteurs, il est nécessaire d'une part de traiter simultanément le plus grand nombre de plaquettes possible et d'autre part de réduire la durée de certains traitements en augmentant la température par exemple.

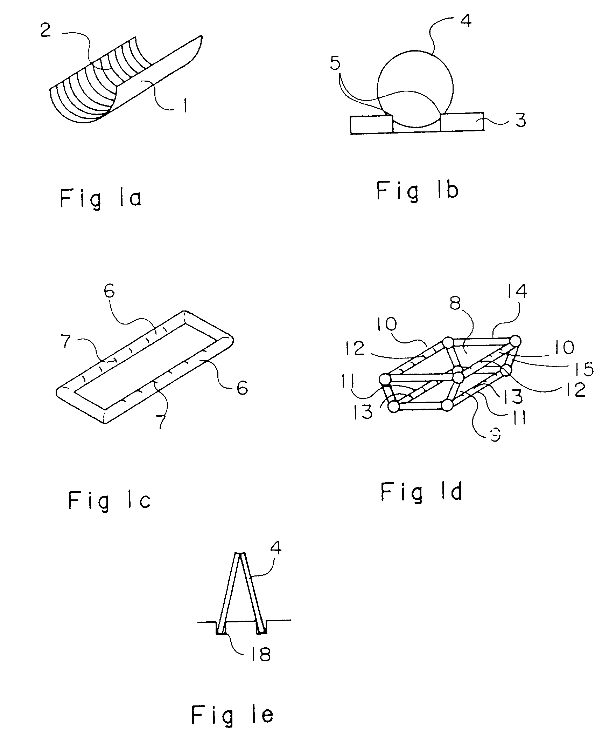

Il existe différents types de nacelles couramment utilisées pour les traitements des plaquettes de silicium. Des exemples de nacelles classiques sont représentés schématiquement en figures 1a à 1d.

La nacelle représentée schématiquement dans la figure 1a est constituée par une coquille 1 en forme de demi-cylindre creux comportant des rainures 2 situées dans la partie concave de la coquille. Cette nacelle procure un bon maintien à des plaquettes de diamètre donné puisque le maintien d'une plaquette est assuré par l'engagement de sa base dans une rainure circulaire, mais elle présente l'inconvénient qu'il est difficile de réaliser un rainurage correct et régulier sur des formes arrondies. De plus cette nacelle ne permet pas une circulation de gaz satisfaisante autour des plaquettes.

La nacelle représentée dans la figure 1b est constituée par un plan rainuré ajouré 3, chaque plaquette de silicium 4 étant maintenue en position verticale en l'insérant dans des rainures 5 de part et d'autre de l'ouverture centrale, ce qui fournit deux zones d'appui de faible étendue proches de la base de la plaquette.

La figure 1c est une vue en perspective d'une nacelle constituée de deux rails parallèles 6 situés dans un même plan horizontal et comportant des encoches 7 également espacées sur les deux rails ; une plaquette de silicium est maintenue en position verticale par engagement simultané dans deux encoches situées en vis-à-vis ce qui donne deux zones d'appui à la base de la plaquette correspondant à la profondeur des encoches.

Un inconvénient des nacelles représentées dans les figures 1b et 1c est illustré par la figure 1e. Avec ces nacelles, le maintien en position verticale des plaquettes de silicium 4 est fourni par deux zones d'appui de faible étendue 18 situées au voisinage du bas des plaquettes et correspondant aux profondeurs de deux rainures ou encoches situées en vis-à-vis. Les plaquettes sont donc susceptibles de présenter une certaine inclinaison. Si le pas de rainurage est faible, cette inclinaison peut entraîner un contact de deux plaquettes de silicium consécutives au niveau de leur sommet entraînant une mauvaise qualité des plaquettes après traitement. On ne peut donc pas prévoir un rainurage serré permettant de traiter simultanément un grand nombre de plaquettes.

Enfin, la nacelle de la figure 1d est réalisée à partir de quatre rails. Les plans supérieur et inférieur de la nacelle, 8 et 9 respectivement, sont horizontaux et comportent chacun une paire de rails parallèles, 10 et 11 respectivement, l'écart des rails inférieurs étant plus faible que celui des rails supérieurs. Ces rails portent des encoches, régulièrement espacées sur leur longueur de sorte qu'une paire d'encoches supérieure 12 et une paire d'encoches inférieure 13 se situent dans un même plan vertical. L'ensemble des rails est lié rigidement par des tiges horizontales 14 et obliques 15. Le maintien en position verticale d'une plaquette de silicium est assuré par son engagement dans deux paires d'encoches 12 et 13 situées dans un même plan vertical qui fournissent ainsi 4 zones d'appuis correspondant à la profondeur des encoches. Une plaquette de silicium est donc mieux maintenue dans cette nacelle que dans les deux précédentes.

Un inconvénient de cette dernière nacelle et plus généralement de toutes les nacelles connues est que, toutes ces nacelles étant rigides, toute contrainte mécanique subie par la nacelle est immédiatement transmise aux plaquettes qui peuvent de ce fait subir des déformations nuisant à leur qualité industrielle. En effet, s'il est néoessaire de travailler à haute température dans le cas de traitements particuliers pour diminuer la durée du cycle de traitement et améliorer ainsi le rendement de production, toutes ces nacelles se déforment par dilatation thermique et en raison de leur rigidité transmettent directement ces déformations aux plaquettes traitées qui présentent donc un défaut de qualité ; par exemple, elles peuvent être gondolées.

En conclusion, les différentes nacelles connues à ce jour étant monobloc et rigides, lorsqu'elles sont utilisées à chargement maximal ou à températures élevées, induisent des contraintes sur les plaquettes de silicium qui se déforment ou sont traitées irrégulièrement, ce qui entraine un surcoût défavorable à l'industrie des composants semiconducteurs.

Ainsi, un objet de la présente invention est de prévoir une nacelle modulable utilisable pour tout diamètre de plaquette de silicium et permettant de remédier aux inconvénients des nacelles antérieures décrites ci-dessus.

Un autre objet de la présente invention est de prévoir une nacelle facilement réalisable et de coût réduit.

Un autre objet de la présente invention est de prévoir une nacelle pouvant être utilisée dans différents types de supports.

Pour atteindre ces objets, la présente invention prévoit une nacelle destinée à recevoir des plaquettes de semiconducteur en position verticale, comportant un berceau en forme de demi-cylindre creux d'axe horizontal ; et deux plaques rainurées, disposées contre les parois latérales du berceau recevant les plaquettes de semiconducteur à traiter, ces deux plaques étant indépendantes l'une de l'autre et s'appuyant sur le berceau sans y être liées.

Selon un mode de réalisation de la présente invention, la nacelle comporte en outre une plaque horizontale permettant le maintien des deux plaques rainurées latérales et servant de guide amovible pendant le chargement des plaquettes de semiconducteur.

Selon un mode de réalisation de la présente invention, les différentes parties sont en quartz, carbure de silicium, silicium polycristallin ou alumine.

Selon un mode de réalisation de la présente invention, la largeur du guide est choisie en fonction du diamètre des plaquettes à traiter et de la hauteur libre que l'on souhaite laisser entre la base de oes plaquettes et le fond du berceau.

Selon un mode de réalisation de la présente invention, la naoelle est placée dans des supports variés tels que palette, goulotte ou contre-tube de diamètre identique ou différent.

Selon un mode de réalisation de la présente invention, la nacelle est munie de pieds porteurs permettant son utilisation directe.

Ces objets, caractéristiques et avantages ainsi que d'autres de la présente invention seront exposés en détail dans la description suivante faite en relation avec les figures jointes parmi lesquelles :
la figure 1, décrite précédemment, représente schématiquement diverses nacelles de l'art antérieur ;
la figure 2 est une vue en perspective d'une nacelle selon la présente invention, non chargée ;
les figures 3, 4 et 5 sont des vues en perspective d'une nacelle selon la présente invention à divers stades de chargement ;
la figure 6 représente une plaque utilisée dans une nacelle selon la présente invention, la figure 6a étant une vue de dessus et la figure 6b une vue de profil ; et
la figure 7 est une vue de face d'une nacelle selon la présente invention, chargée.

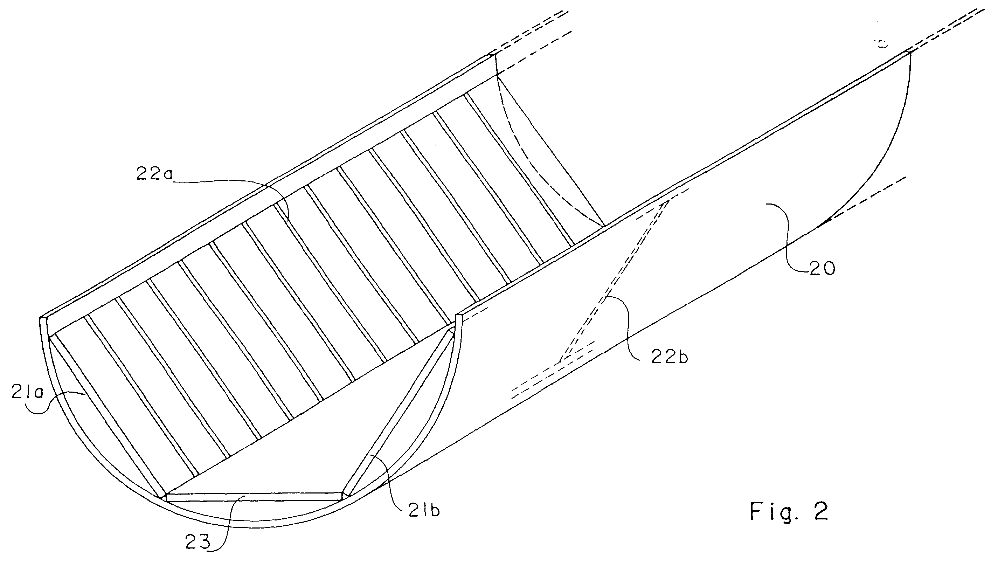

Comme le représente la figure 2, une nacelle selon la présente invention comprend quatre éléments indépendants :
(a) un support ou berceau 20, en forme de demi-cylindre creux d'axe horizontal, en un matériau tel que du quartz, du carbure de silicium, du silicium polycristallin ou de l'alumine,
(b) deux plaques 21a et 21b munies de rainures respectives 22a et 22b à pas strictement identique, également en un matériau tel que du quartz, du carbure de silicium, du silicium polycristallin ou de l'alumine, et
(c) une troisième plaque 23 constituant un guide de chargement amovible dont le rôle sera décrit ci-après.

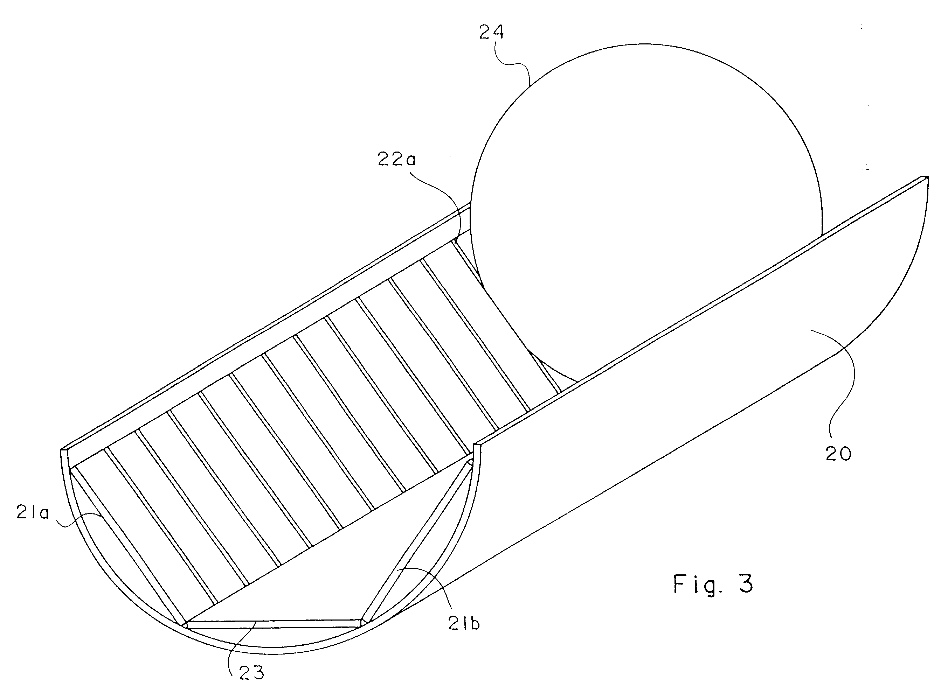

Les figures 3, 4 et 5 illustrent trois étapes successives de chargement d'une nacelle selon la présente invention.

La première étape, illustrée en figure 3, consiste, à l'aide du guide amovible 23 disposé horizontalement dans le creux du support demi-cylindrique 20, à maintenir les deux plaques rainurées 21a et 21b appliquées contre les parois internes du berceau de sorte que les trois plaques 21a, 21b et 23 forment un U ouvert dans le plan vertical et que les rainures 22a et 22b se trouvent en regard les unes des autres.

L'ensemble étant stable, on glisse alors une première plaquette de silicium 24 simultanément dans les deux rainures 22a et 22b situées en vis-à-vis et au fond du berceau 20.

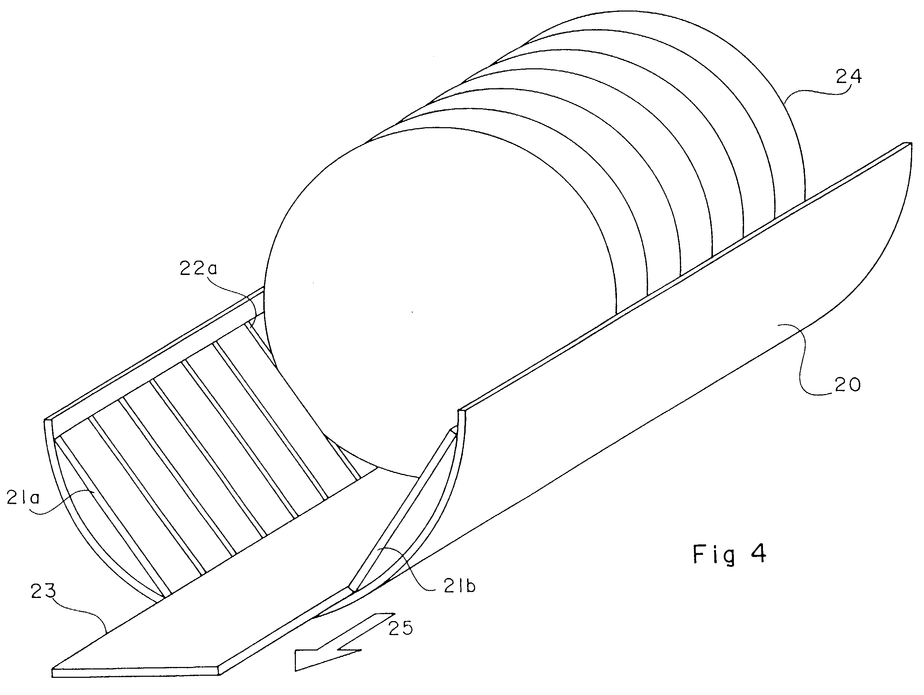

On place ensuite une autre plaquette de silicium dans les rainures adjacentes aux deux premières 22a et 22b et ainsi de suite. Comme le représente la figure 4, au fur et à mesure que l'on introduit les plaquettes de silicium de cette manière dans le berceau 20, on retire par translation vers l'avant la plaque 23 servant de guide (flêche 25).

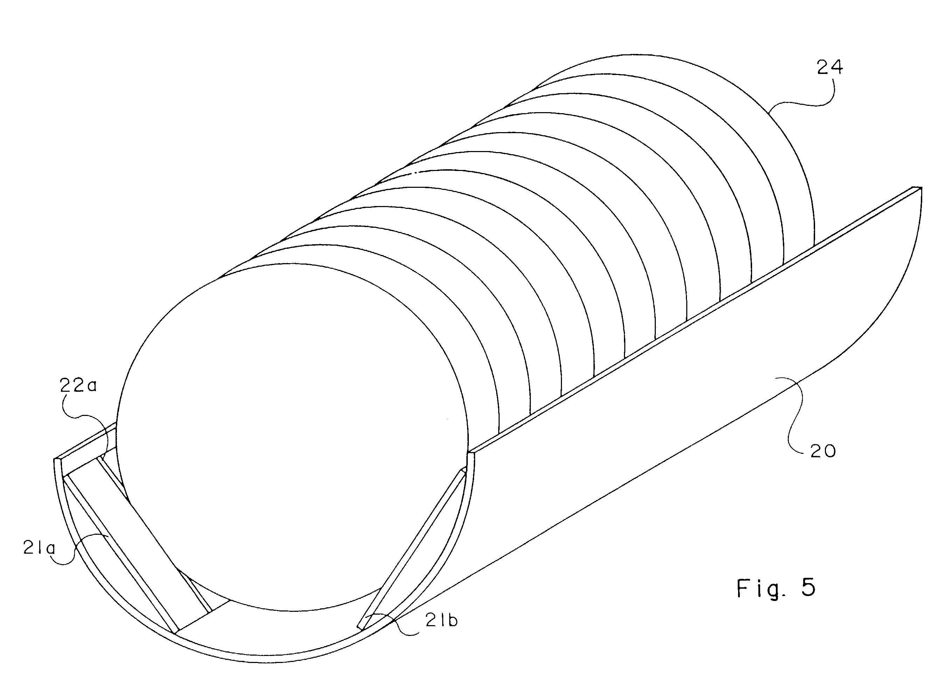

Lorsque le berceau 20 est totalement chargé, comme le représente la figure 5, le guide 23 est donc retiré du berceau 20. La cohésion de la nacelle ainsi chargée est assurée par la seule pression des plaquettes de silicium sur les plaques latérales rainurées 21a et 21b.

On pourra aussi procéder à un chargement groupé de plaquettes à l'aide de machines de transfert classiques. Le guide 23 est alors enlevé en fin de chargement.

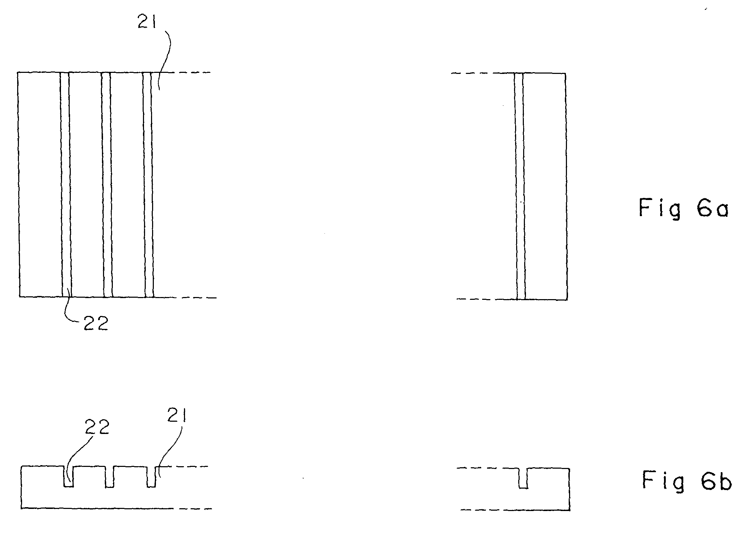

Comme le représentent la figure 6a en vue de dessus et la figure 6b en vue de profil, les plaques 21 sont particulièrement simples à fabriquer. Les rainures peuvent être formées avec précision par usinage ou par microlithogravure.

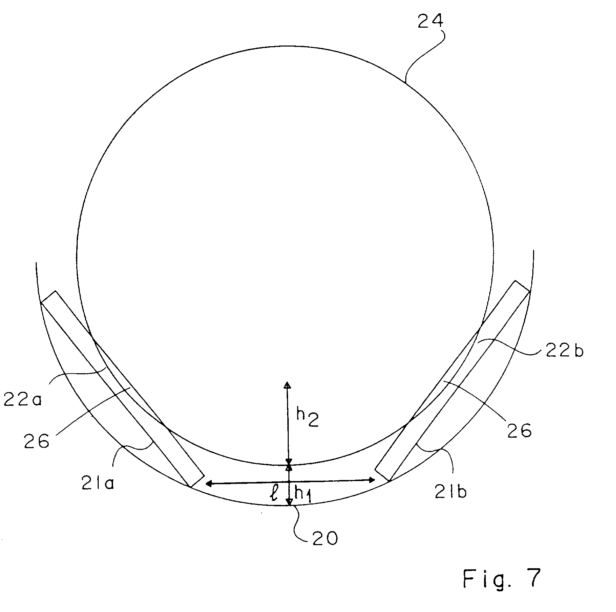

La figure 7 représente une vue de face d'une nacelle selon la présente invention chargée de plaquettes 24. Dans cette figure, on désigne par h1 la hauteur libre entre le bas des plaquettes et le fond du berceau 20, par h2 la hauteur entre la région de maintien des plaquettes dans les rainures 22 des plaques 21 et le bas de ces plaquettes et par 1 l'écart à la base des plaques rainurées 21 correspondant à la largeur du guide de chargement 23 .

La nacelle selon l'invention et son mode de chargement présentent de nombreux avantages.

Tout d'abord, grâce à sa conception nouvelle assurant l'indépendance de ses différentes parties constituantes, elle autorise le traitement de plaquettes de tout diamètre.

De plus, comme le montre la figure 7, les zones d'appui 26 d'une plaquette de silicium 24 dans les rainures 22 des plaques latérales 21 sont relativement étendues ce qui empêche toute inclinaison d'une plaquette vers l'avant ou vers l'arrière du plan vertical et garantit le parallélisme des plaquettes quelle que soit la position des plaques. On pourra donc juxtaposer un grand nombre de plaquettes de silicium sur une faible distance, par exemple environ 600 plaquettes sur 80 cm, sans risque de contact entre deux plaquettes consécutives comme dans le cas de certaine des naoelles de l'art antérieur décrites ci-dessus.

D'autres avantages sont liés directement à l'indépendance des éléments de la nacelle selon la présente invention.

Le choix de l'écart 1 et de la hauteur h₁ permet de régler la circulation des gaz de traitement sous l'ensemble des plaquettes. Si pour des plaques 21 données et des plaquettes 24 de diamètre donné, on veut modifier l'une des hauteurs h₁ ou h₂, il suffit de changer le guide 23 utilisé : par exemple si l'on souhaite augmenter h₁ ou h₂, il faudra augmenter 1, c'est-à-dire utiliser un guide plus large. On peut aussi envisager de régler les hauteurs h₁ et h₂ sans changer de guide mais en utilisant des plaques rainurées 21 différentes. Ainsi, pour des plaquettes de diamètre donné et un guide de largeur donnée, on peut augmenter h₁ ou h₂ en utilisant des plaques 21 plus larges. De même, si l'on veut réutiliser la nacelle pour des plaquettes de diamètre différent, par exemple plus grand, tout en conservant la même hauteur h₁ pour assurer un bon traitement, il suffira d'effectuer le chargement à l'aide d'un guide plus large sans changer les plaques 21 ou d'utiliser des plaques 21 moins larges sans changer de guide. En conclusion, grâce à l'indépendance des éléments de la nacelle, les hauteurs h₂ et h₁ sont facilement réglées pour des plaquettes de diamètres variés.

Cette indépendance des éléments constitutifs de la nacelle selon la présente invention entraîne encore d'autres avantages. En effet, la nacelle étant chargée de plaquettes 24, si les plaques 21 ou le berceau 20 subissent des contraintes mécaniques cela se traduit par un léger déplacement des plaques 21 qui ainsi ne transmettent pas ces contraintes aux plaquettes qui ne risquent plus d'être déformées et traitées irrégulièrement. En outre, si l'on traite des plaquettes de silicium à haute température (1250°C à 1300°C) les phénomènes de dilatation thermique des différentes parties de la nacelle selon la présente invention entraînent, là encore, seulement un léger déplacement des plaques sans modifier le maintien des plaquettes ce qui évite la déformation de ces dernières en particulier le gondolement des plaquettes minces qui résultait de l'emploi des nacelles antérieures.

Enfin, les éléments caractéristiques mis en oeuvre dans cette conception de nacelle et de chargement présentent un faible coût d'élaboration.

La nacelle selon l'invention pourra être utilisée de façon classique comme la nacelle de la figure 1a. Elle peut être placée dans des supports variés tels que palette, goulotte ou contre-tube de diamètre identique ou différent. Elle peut aussi être munie de pieds porteurs permettant son utilisation directe.

## Revendications

1. Nacelle destinée à recevoir des plaquettes de semiconducteur en position verticale, caractérisée en ce qu'elle comporte :
un berceau (20) en forme de demi-cylindre creux d'axe horizontal ; et
deux plaques rainurées (21a, 21b), disposées contre les parois latérales du berceau (20) recevant les plaquettes de semiconducteur à traiter, ces deux plaques (21a, 21b) étant indépendantes l'une de l'autre et s'appuyant sur le berceau sans y être liées.

2. Nacelle selon la revendication 1, caractérisée en ce qu'elle comporte en outre une plaque horizontale (23) permettant le maintien des deux plaques rainurées latérales (21a, 21b) et servant de guide amovible pendant le chargement des plaquettes de semiconducteur.

3. Nacelle selon l'une des revendications 1 ou 2, caractérisée en ce que les différentes parties sont en quartz, carbure de silicium, silicium polycristallin ou alumine.

4. Nacelle selon la revendication 2, caractérisée en ce que la largeur du guide (23) est choisie en fonction du diamètre des plaquettes à traiter et en fonction de la hauteur libre (h1) que l'on souhaite laisser entre la base de ces plaquettes et le fond du berceau (20).

5. Nacelle selon la revendication 1, caractérisée en ce qu'elle est placée dans des supports variés tels que palette, goulotte ou contre-tube de diamètre identique ou différent.

6. Nacelle selon la revendication 1, caractérisée en ce qu'elle est munie de pieds porteurs permettant son utilisation directe.

## Patentansprüche

1. Trägerkassette zur Aufnahme von Halbleiterscheiben in vertikaler Position, dadurch gekennzeichnet, daß sie aufweist:
einen Träger (20) in Form eines hohlen Halbzylinders mit hoher horizontaler Achse; und
zwei mit Rillen versehene Platten (21a, 21b), die sich an den seitlichen Wänden des Trägers (20) abstützen und die zu behandelnden Halbleiterscheiben aufnehmen, wobei diese beiden Platten (21a, 21b) unabhängig voneinander sind und an dem Träger anliegen, ohne damit verbunden zu sein.

2. Trägerkassette nach Anspruch 1, dadurch gekennzeichnet, daß sie zudem eine horizontale Platte (23) aufweist, um die beiden gerillten seitlichen Platten (21a, 21b) zu halten und die als entfernbare Führung während des Einladens der Halbleiterscheibe dient.

3. Trägerkassette nach einem der Ansprüche 1 oder 2, dadurch gekennzeichnet, daß die verschiedenen Teile aus Quarz, Siliziumkarbid, polykristallinem Silizium oder Aluminium bestehen.

4. Trägerkassette nach Anspruch 2, dadurch gekennzeichnet, daß die Breite der Führung (23) als Funktion des Durchmessers der zu behandelnden Scheiben und als Funktion der freien Höhe gewählt ist, die zwischen dem unteren Rand dieser Scheiben und dem Boden des Trägers (20) frei bleiben soll.

5. Trägerkassette nach Anspruch 1, dadurch gekennzeichnet, daß sie in unterschiedlichen Aufnahmen plaziert ist, so z.B. einer Palette, einer Rutsche oder einem Gegenrohr mit identischem oder unterschiedlichem Durchmesser.

6. Trägerkassette nach Anspruch 1, dadurch gekennzeichnet, daß sie mit Trägerfüßen ausgerüstet ist, um ihren direkten Gebrauch zu ermöglichen.

## Claims

1. A boat for vertically holding semiconductor wafers, characterized in that it includes:
a cradle (20) made of a hollow half cylinder with a horizontal axis; and
two grooved plates (21a, 21b), disposed against the lateral walls of said cradle (20) accommodating the semiconductor wafers to be treated, said two plates (21a, 21b) being independent and abutting against the cradle without being fastened thereto.

2. The boat of claim 1, characterized in that it further includes a horizontal plate (23) for maintaining said two lateral grooved plates (21a, 21b) and serving as a removable guide during the loading of the semiconductor wafers.

3. The boat of claim 1 or 2, characterized in that the various parts are made of quartz, silicon carbide, polycrystalline silicon or alumina.

4. The boat of claim 2, characterized in that the width of the guide (23) is selected as a function of the diameter of the wafers to be treated and as a function of the free height (h₁) that it is desired to leave between the base of said wafers and the bottom of the cradle (20).

5. The boat of claim 1, characterized in that it is placed in various supports, such as a pallet, a chute or a counter-tube having an identical or a different diameter.

6. The boat of claim 1, characterized in that said cradle further comprises supporting legs that allow it to be directly used.
